# FASCICULE DE BREVET EUROPEEN

(11) **EP 2 887 153 B1**
(45) Date de publication et mention de la délivrance du brevet: **28.06.2023**
(21) Numéro de dépôt: 13198643.2
(22) Date de dépôt: 19.12.2013
(51) Int. Cl.: G04B 17/32, F16C 32/04, G04B 31/00

(54) **Dispositif de centrage magnétique**
Magnetische Zentriervorrichtung
Magnetic centring device

(43) Date de publication de la demande: 24.06.2015
(73) Titulaire: Montres Breguet SA, 1344 L'Abbaye (CH)
(72) Inventeur: Tadla, Camille, 01170 Echenevex (FR); Poux, Philippe, 25660 Montfaucon (FR); Rochat, Jean-Philippe, 1346 Les Bioux (CH); Sarchi, Davide, 1020 Renens (CH)
(74) Mandataire: ICB SA

(56) Documents cités:
- EP-A1- 0 695 027
- DE-A1-102008 035 509

## Description

La présente invention concerne un dispositif de centrage magnétique pour des composants de faible taille, notamment pour le centrage d'un composant monté en pivot. Un domaine d'application particulier de l'invention concerne les mécanismes horlogers.

L'introduction de composants magnétiques actifs tels que des aimants permanents et des pièces en matériau ferromagnétique doux dans les mécanismes horlogers représente un défi technique important à cause des dimensions extrêmement réduites et de la grande précision spatiale demandée pour accomplir les fonctions chronométriques de manière fiable.

La plupart des matériaux magnétiques naturels ou synthétisés sont inhomogènes à l'échelle d'un millimètre ou moins, ce qui rend difficilement maitrisable la localisation et l'intensité des champs magnétiques à cette échelle. Notamment, les micro-aimants permanents présentant la plus haute densité d'énergie magnétique, par exemple des micro-aimants en SmCo ou NdFeB, sont typiquement fabriqués à partir de poudres d'éléments chimiques appartenant à la famille des terres rares, leur structure granulaire comportant des dimensions comprises entre 1 et 100 microns. L'homogénéité du champ magnétique diminue généralement en s'approchant de l'échelle des grains.

L'utilisation de composants magnétiques pour des organes rotatifs de mouvements ou mécanismes horlogers, par exemple tels que décrits dans WO2012/0662524 et WO2012/062523, ou d'autres mécanismes micromécaniques, tels que dans des instruments de mesure ou de contrôle, est avantageuse parce qu'elle permet de créer des forces importantes et localisées accompagnées de frottements faibles.
On connaît également du document DE102008035509 un moteur de broche muni d'un palier axial magnétique.
Le document EP 0695027 décrit un dispositif de lévitation magnétique. Dans certains modes de réalisation, ce dispositif prend la forme d'un palier magnétique pour objets pivotants.

Un objet de l'invention est de fournir un dispositif de centrage magnétique pour des composants de faible taille, à l'échelle millimétrique ou moins, qui soit précis et fiable.

Un objet particulier de l'invention est de fournir un dispositif de centrage magnétique pour un composant monté en pivot.

Un objet particulier de l'invention est de fournir un dispositif de centrage magnétique pour un composant d'un mécanisme horloger, et un mécanisme horloger comprenant un dispositif de centrage magnétique.

Il est avantageux de fournir un dispositif de centrage magnétique intégrant un palier à très faible usure pour un organe rotatif.

Il est avantageux de fournir un dispositif de centrage magnétique intégrant un palier ayant un rendement élevé.

Il est avantageux de fournir un dispositif de centrage magnétique très compact et robuste.

Il est avantageux de fournir un dispositif de centrage magnétique qui peut être fabriqué de manière simple et économique.

Des objets de l'invention sont réalisés par un dispositif de centrage magnétique selon la revendication 1. Les revendications dépendantes décrivent des aspects avantageux de l'invention.

Des objets de l'invention sont réalisés par un mouvement de montre selon la revendication 22.

Des objets de l'invention sont réalisés par une montre selon la revendication 23.

L'intégration d'éléments de localisation du flux magnétique aux composants magnétiques actifs selon la présente invention améliore et étend l'utilisation des composants magnétiques, notamment des composants magnétiques horlogers.

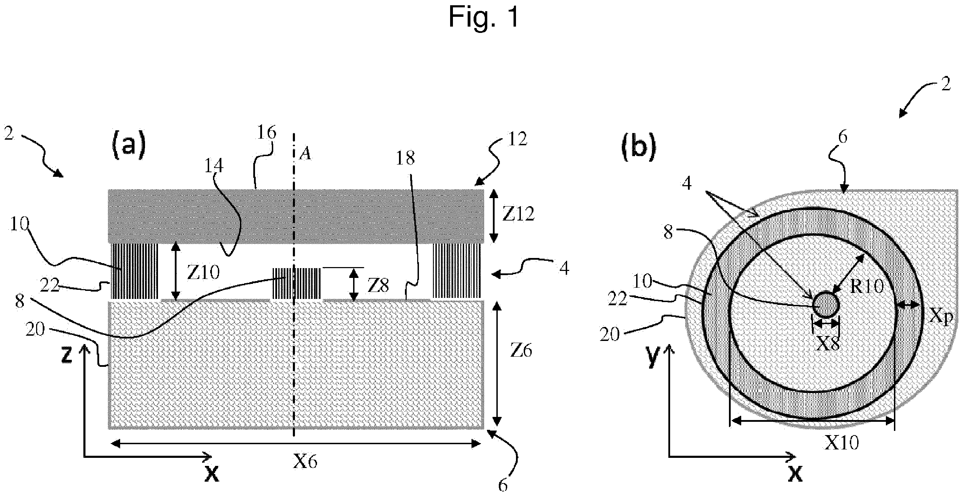

D'autres buts et aspects avantageux de l'invention apparaitront à la lecture de la description détaillée de formes d'exécution ci-après, et des dessins annexés, dans lesquels :
La Fig. 1 est un schéma de principe d'une forme d'exécution d'un dispositif de centrage magnétique selon l'invention, la Fig. 1a illustrant une vue en coupe et la Fig. 1b une vue de dessus dudit dispositif ;
La Fig. 2 est un schéma illustrant le champ magnétique d'un dispositif de centrage magnétique selon une forme d'exécution de l'invention ;
La Fig. 3 est un graphique illustrant l'amplitude du champ magnétique en présence et en absence d'un composant de localisation du flux magnétique d'un dispositif de centrage magnétique selon une forme d'exécution de l'invention ;
Faisant référence aux figures, notamment aux figures 1a et 1b, un dispositif de centrage magnétique 2 selon une forme d'exécution de l'invention comprend un aimant 6, un support amagnétique 12 et un dispositif de conduction de flux magnétique 4 disposé entre l'aimant et le support amagnétique. L'aimant 6 peut être en un matériau présentant une haute densité d'énergie magnétique par exemple en SmCo ou NdFeB, qui sont typiquement fabriqués selon des procédés connus en soi à partir de poudres d'éléments chimiques appartenant à la famille des terres rares. Dans le cadre de l'invention, il est possible, dans une autre forme d'exécution, de ne pas avoir de support amagnétique.

Pour des applications visées par l'invention, l'épaisseur Z6 de l'aimant est de l'ordre d'un millimètre ou moins, par exemple entre 0,2 et 0,7 millimètres. Pour des applications nécessitant une très grande force magnétique, la hauteur Z6 de l'aimant pourrait aussi être de l'ordre de quelques millimètres, par exemple de 1 à 5 millimètres. Pour des applications visées par l'invention, la largeur moyenne X6 de l'aimant, ou son diamètre s'il s'agit de l'aimant de forme cylindrique, est de l'ordre de grandeur millimétrique, typiquement inférieur à 5 millimètres et dans de nombreuses applications de l'ordre d'un millimètre ou moins. Selon une forme d'exécution préférée, l'aimant 6 a une forme prismatique, avec un profil circulaire, polygonal, carré, rectangulaire ou encore des formes irrégulières tel qu'illustré dans la figure 1b.

Pour la plupart des applications, le profil de l'aimant est de préférence circulaire.

Le support amagnétique 12 est en un matériau non magnétique, le choix de matériau dépendant entre autre de l'application envisagée pour le dispositif de centrage magnétique 2. Le support amagnétique 12 protège le dispositif de conduction de flux magnétique 4 et présente une surface de travail 16 contre laquelle un organe (non illustré) peut prendre appui.

Une des applications principales du dispositif de centrage magnétique selon une forme d'exécution de l'invention comprend la fonction de palier axial pour des pièces mobiles rotatives ou pivotantes le palier axial ayant aussi la fonction de centrer l'organe mobile rotatif sur un axe A défini par le dispositif de conduction de flux magnétique 4. Le dispositif de centrage magnétique selon l'invention peut également être utilisé pour le centrage ou le positionnement de pièces non rotatives, et notamment de pièces statiques. Dans ce cas, il est également envisageable d'utiliser le dispositif de centrage magnétique selon l'invention pour définir un point de référence, par exemple pour une pièce mobile.

Selon l'invention telle que revendiquée, le support amagnétique 12 présente une surface de travail 16 pour un appui d'organe mobile (non illustré) par exemple pour une réalisation en tant que palier axial d'un organe pivotant rotatif. Dans ce cas, le matériau est choisi parmi des matériaux ayant de bonnes propriétés mécaniques, et notamment ayant une limite de déformation et de rupture élevée ainsi que de bonnes propriétés tribologiques. Des exemples de matériaux répondant à ces critères comprennent les pierres cristallines telles que des saphirs, par exemple des pierres de rubis ou de diamant. Pour des pièces mobiles horlogères, on utilisera de préférence des pierres de rubis en tant que matériau pour le support amagnétique 12.

Dans une forme d'exécution préférée le support amagnétique est composé d'un matériau homogène, par exemple un support amagnétique consistant en une pastille de saphir par exemple une pierre de rubis. Toutefois, dans le cadre de l'invention le support amagnétique peut également être formé d'une structure non homogène formée de plusieurs couches de différents matériaux. Par exemple, dans une variante, le support amagnétique 12 peut comprendre un premier matériau comme matériau principal pour le corps du support, un deuxième matériau de grande dureté et/ou ayant de bonnes propriétés tribologiques formant une couche extérieure comprenant la surface de travail 16. Par exemple, une première couche peut être en un matériau formé par déposition selon des techniques de déposition connues sur le dispositif de conduction de flux magnétique 4, et une deuxième couche peut en un autre matériau. Cette deuxième couche peut par exemple être une couche en diamant, également formée par des techniques de déposition tels que par plasma ou CVD (Chemical Vapor Déposition).

Le support amagnétique peut également être sous forme d'une pièce unique telle qu'un rubis ou autre pierre taillée ou d'une pièce en matériau céramique.

L'épaisseur axiale Z12 du support amagnétique est de préférence de l'ordre de grandeur d'un millimètre ou moins, de préférence inférieur à 0,5 millimètres. Pour la plupart des applications, l'épaisseur Z12 est aussi faible que possible tenant compte des contraintes exercées sur le support amagnétique et de la résistance des matériaux qui le forment, ainsi que des limites techniques de fabrication utilisées pour produire le dispositif. Cela permet d'avoir une distance axiale séparant la surface de travail 16 du dispositif de conduction de flux magnétique 4 aussi faible que possible pour une intensité de champ magnétique aussi grande que possible.

La surface de travail 16 peut être plane ou essentiellement plane. Toutefois, dans des variantes, la surface de travail peut avoir une forme non plane par exemple une forme convexe, ou une forme concave, ces formes dépendant entre autre de l'application envisagée pour le dispositif de centrage magnétique selon l'invention.

Une forme convexe peut être utile par exemple lorsque le dispositif de centrage magnétique est disposé sur l'extrémité d'un axe de rotation ou lorsque l'organe (non illustré) venant en appui contre la surface de travail présente une surface plane ou concave, afin de former un point de contact entre l'organe et la surface de travail.

Dans une forme d'exécution, la largeur du support amagnétique peut être identique ou correspondre essentiellement à la largeur X6 de l'aimant. Il est toutefois possible dans des variantes d'avoir un support amagnétique 12 ayant une largeur et/ou un profil différent de la largeur et du profil de l'aimant. Par exemple dans une variante le support amagnétique peut faire partie, solidaire ou intégré, d'un élément support plus grand et ayant d'autres fonctions et/ou formant partie d'un organe d'un autre dispositif.

Le dispositif de conduction de flux magnétique 4 comprend une pastille centrale de conduction de flux magnétique 8 en un matériau magnétique M1 et un pourtour 10 en un matériau M2 qui peut, selon la variante, être identique au matériau M1 de la pastille centrale, ou être en un matériau différent du matériau de la pastille centrale.

Le pourtour 10 est disposé autour de la pastille centrale et est séparé de la pastille centrale par une distance R10. Dans une forme d'exécution avantageuse, le pourtour n'est pas en contact avec la pastille centrale. Dans une variante, le pourtour et la pastille centrale sont connectés par une ou plusieurs barrettes, rayons ou ponts d'autres formes. Le pourtour et la pastille centrale peuvent aussi être connectés par une ou un plateau de liaison d'épaisseur égale ou inférieure à un dixième de l'épaisseur de la pastille centrale. La distance R10 peut être de l'ordre de grandeur de la moitié de la largeur X6 de l'aimant moins l'épaisseur radiale Xp du matériau formant le pourtour et le rayon (X8/2) de la pastille centrale 8. Dans une forme d'exécution, le pourtour se trouve à proximité de la périphérie externe 20 de l'aimant 6 ou de la périphérie externe 22 du support amagnétique 12. La distance R8 séparant la pastille centrale du pourtour est, dans des formes d'exécution préférentielles, dans une gamme se trouvant entre 0,45 et 0,2 fois la largeur moyenne X6 de l'aimant. Si l'aimant a une largeur d'environ 1 millimètre, la distance séparant le pourtour de la pastille centrale se situe de préférence entre 0,45 et 0,2 millimètres.

Dans une forme d'exécution préférentielle, le pourtour 10 forme un circuit fermé autour de la pastille centrale, de préférence circulaire, toutefois le pourtour peut également avoir une forme de triangle ou de polygone régulier ou de carré, la pastille centrale étant disposée de préférence au centre du pourtour 10 dans la limite des tolérances de fabrication. Dans des variantes (non illustrées) le pourtour 10 peut également être formé d'un circuit non fermé entourant la pastille centrale, ou comprendre une pluralité de points, d'arcs de cercle, ou de sections de matériaux M2 discontinues mais distribuées autour de la pastille centrale de conduction du flux magnétique 8.

Dans une forme d'exécution préférée, le matériau M2 du pourtour 10 est avantageusement un matériau de conduction de flux magnétique, notamment ayant une haute perméabilité magnétique. Dans cette forme d'exécution, le matériau M2 peut avantageusement être le même matériau de conduction de flux magnétique utilisé pour la pastille centrale de conduction de flux magnétique 8. Dans une variante, il est toutefois possible d'avoir un matériau M2 ayant une faible perméabilité magnétique, notamment un matériau amagnétique et dans ce cas le pourtour a une fonction de support et/ou d'espacement définissant la distance axiale Z10 entre une surface de l'aimant 6 et une surface intérieure 14 du support amagnétique 12.

Dans une forme d'exécution préférée, le dispositif de conduction de flux magnétique 4 est formé par une technique de déposition, soit sur la surface 18 de l'aimant, soit sur la surface intérieure 14 du support amagnétique. Diverses techniques de déposition connues dans l'état de la technique peuvent être utilisées et ne seront donc pas décrites en détail. L'un des procédés connus qui peut être avantageusement utilisé dans une forme d'exécution de l'invention comprend la déposition d'une couche de matériau M1 formant la pastille centrale, le cas échéant d'un autre matériau M2 formant le pourtour si celui-ci est différent du matériau de la pastille centrale, suivi par un procédé de lithographie pour former la pastille centrale et l'espace R8 séparant la pastille centrale 8 du pourtour 10. Selon une variante, le procédé de fabrication de la pastille centrale et du pourtour peut comprendre un usinage par laser d'une couche de matériau formant la pastille centrale et le pourtour. Selon une variante, le support amagnétique 12 peut comprendre un creux central par exemple un creux usiné par laser dans un matériau dur tel qu'une pierre en saphir ou une pièce en céramique le matériau magnétique de la pastille centrale étant déposé dans le creux par exemple par dépôt galvanique, le cas échéant accompagné par un procédé d'attache mécanique ou chimique pour former la forme finale de la pastille centrale et du pourtour. On peut également utiliser le même procédé pour former le pourtour en formant un creux pour le pourtour. Le creux formé dans le support peut également englober la pastille centrale et le pourtour l'espace entre la partie centrale et le pourtour étant usiné, enlevé par attaque chimique, ou par un procédé laser. Dans une forme d'exécution préférée, le creux dans le support magnétique 12 peut être inscrit dans un cône tronqué ayant le diamètre le plus petit vers le fond du creux.

L'espace séparant le pourtour de la pastille centrale peut être rempli d'un gaz, ou dans une variante préférentielle peut être rempli d'un matériau solide amagnétique, à savoir un matériau ayant une faible perméabilité magnétique, par exemple proche d'une valeur de 1.

Le matériau M1 de la pastille centrale 8, le cas échéant du pourtour 10 lorsqu'il s'agit du même matériau, peut avantageusement être réalisé en nickel ou en cobalt ou en des alliages de nickel ou de cobalt. Dans une forme d'exécution le matériau M1 et/ou le matériau M2 est réalisé intégralement en nickel. Dans une autre variante, ces éléments sont réalisés intégralement en nickel-phosphore avec un pourcentage de phosphore inférieur ou égal à 11%. Selon encore une autre variante l'élément de conduction de flux est réalisé intégralement en cobalt. Selon une autre variante l'élément de conduction de flux peut être réalisé intégralement en un matériau magnétiquement doux, caractérisé par un champ coercitif H_{c} inférieur à 5 kA/m et une perméabilité µ_{R} maximale égale ou supérieure à 100.

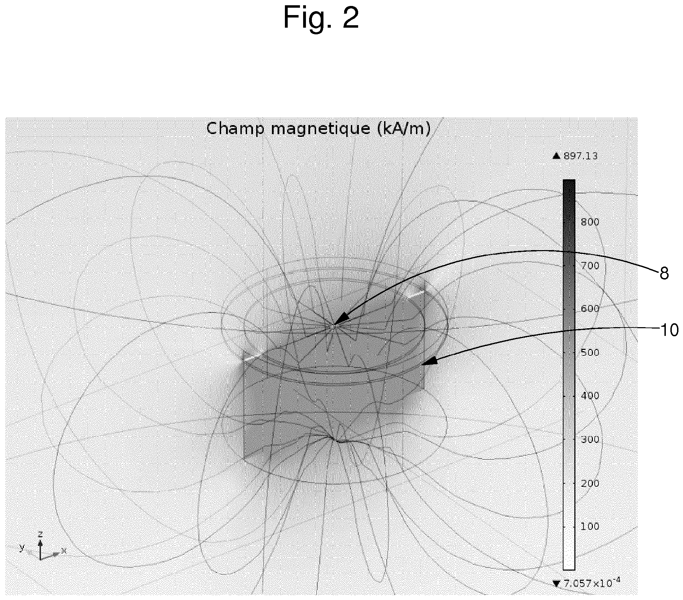

La figure 2 illustre des lignes de champ magnétique résultant d'un dispositif de centrage magnétique selon la figure 1. Les lignes de champ sont localisées dans la région de la pastille centrale 8, difficilement visible à l'échelle réelle. La pastille centrale 8 dans cet exemple a un diamètre égal à 10 microns et une épaisseur égale à 10 microns. Le pourtour 10 a une forme de couronne circulaire avec un diamètre extérieur égal à 1 mm et un diamètre intérieur égal à 0.8 mm, et une épaisseur égale à 10 microns. La pastille et le pourtour sont réalisés en Nickel. Le dispositif de conduction de flux magnétique 4 est interposé entre un aimant permanent en NdFeB de diamètre égal à 1 mm et épaisseur égale à 0.5 mm et une pierre en rubis ayant le même diamètre et une épaisseur égale à 0.05 mm.

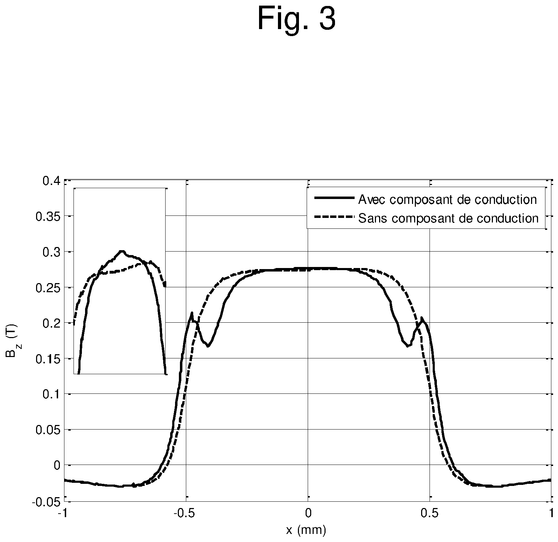

Le champ rémanent de l'aimant permanent est 1 T et son aimantation est inhomogène et décentrée par rapport au centre de l'aimant de 0.2 mm. Le champ magnétique sur la surface externe de la pierre en rubis est montre en Figure 3. Dans la figure 3, l'amplitude du champ magnétique et mesuré dans une direction selon l'axe x sur une coupe suivant l'axe y=0, z=0.31 mm en présence et en absence d'un élément de conduction d'un flux magnétique B. Le maximum du champ est en correspondance avec la pastille centrale en Nickel qui joue un rôle de conducteur et localisateur du flux magnétique sortant de l'aimant. En absence de l'élément de conduction, le maximum du champ magnétique sur la pierre serait décalé d'environ 0.2 mm, à cause du décentrage de l'aimantation de l'aimant permanent.

Selon un mode de réalisation avantageux, l'élément de conduction du flux magnétique comprend une pastille centrale circulaire de diamètre égal ou inférieur à 10 microns et d'épaisseur égal ou inférieur à 7 microns.

Selon un mode de réalisation avantageux, l'élément de conduction du flux magnétique comprend une pastille centrale qui peut être inscrite dans un cône tronqué ayant une première surface de diamètre égal ou inférieur à 10 microns et une deuxième surface de diamètre égal ou inférieur à 50 microns et par une hauteur égale ou inférieure à 50 microns, la surface la plus grande étant la surface la plus proche de l'aimant 6.

Selon un mode de réalisation avantageux, la distance minimale entre la pastille centrale et le pourtour est égale ou supérieure à 0.2 mm.

Selon un mode de réalisation avantageux, le pourtour a la forme d'une couronne circulaire.

Selon un mode de réalisation avantageux le pourtour est complètement déconnecté de la pastille centrale.

Selon un deuxième mode de réalisation un élément amagnétique de connexion existe entre le pourtour et la pastille centrale.

Selon un mode de réalisation le pourtour et la pastille sont réalisés dans le même matériau et connectés par une barrette ou un plateau de liaison d'épaisseur égale ou inférieure à un dixième de l'épaisseur de la pastille.

De préférence, l'aimant est un aimant permanent en terres rares.

Selon un mode de réalisation avantageux, les matériaux M1 et M2 sont identiques.

Selon un mode de réalisation avantageux, l'élément de conduction du flux est réalisé intégralement en Nickel.

Selon une variante, le dispositif de conduction de flux magnétique est réalisé intégralement en Nickel-Phosphore avec un pourcentage de phosphore inférieure ou égale à 11%.

Selon une variante, le dispositif de conduction de flux magnétique est réalisé intégralement en Cobalt.

Selon une variante le dispositif de conduction de flux magnétique est réalisé intégralement en un matériau magnétiquement doux, caractérisé par un champ coercitif H_{c} inférieur à 5 kA/m et une perméabilité µ_{R} maximale égale ou supérieure à 100.

Selon un autre mode de réalisation, le matériau M1 est magnétique et le matériau M2 est amagnétique.
Selon une autre mode de réalisation, le support amagnétique est absent.

Selon un procédé de fabrication avantageux le dispositif de conduction de flux magnétique est réalisé par dépôt sur la surface de l'aimant.

Selon un procédé de fabrication avantageux le dispositif de conduction de flux magnétique est réalisé par dépôt sur la surface du support amagnétique.

Selon un procédé de fabrication avantageux le dispositif de conduction de flux magnétique est obtenu par lithographie à partir d'une couche uniforme de matière.

Selon un procédé de fabrication avantageux, la surface du support amagnétique est creusée par usinage laser, le matériau M1 est ensuite déposé uniformément par dépôt galvanique sur la surface creusée et le dispositif de conduction de flux magnétique est finalement formé à l'intérieur du creux, par attaque mécanique ou chimique du matériau M1 déposé. Selon un procédé de fabrication préféré, le creux dans le support magnétique peut être inscrit dans un cône tronqué ayant le diamètre le plus petit vers le fond du creux.

Parmi les applications horlogères, un dispositif de centrage magnétique selon l'invention peut avantageusement être utilisé dans:
- un mouvement de montre mécanique, notamment pour le balancierspiral et l'échappement;
- un pivot magnétique pour divers pièces mobiles tels que de rouage, d'échappement, ou de balancier;
- un chronographe (oscillateur, mobile et anti-flottement) ;
- un mécanisme quantième (semi-instantané et instantané) ;
- un mécanisme de sonnerie (marteau-timbres, claviers, régulateurs) ;
- un montre a diapason (notamment avec un échappement Clifford)

L'invention peut aussi être utilisée dans des instruments de mesure ou de commande et d'autres instruments comprenant des composants rotatifs micromécaniques, par exemple des gyroscopes miniatures.

Parmi les avantages, un dispositif de centrage magnétique selon l'invention:
- permet d'assurer la localisation du flux magnétique sortant d'un composant magnétique de taille horlogère avec une précision inférieure à 10 microns ;
- s'intègre à tous les composants magnétiques actifs (aimants permanents, composants ferromagnétiques doux, antiferromagnétique etc...) ; indépendamment de leur densité d'énergie magnétique, de leur rémanence magnétique et des autres propriétés magnétiques du composant ;
- peut être directement intégré aux composants déjà développés dans l'industrie horlogère, par exemple dans les pivots magnétiques ;
- assure sa fonction de localisation du flux magnétique indépendamment des différentes conditions climatiques, dans un intervalle de températures très élevé (selon le matériau choisi, dans un intervalle supérieur à -200°C / + 150°C).
- assure la localisation du flux indépendamment de son intensité.
- est robuste aux chocs.

### Liste de références

- dispositif de centrage magnétique 2
- dispositif de conduction de flux magnétique 4
- pastille centrale de conduction de flux magnétique 8
- matériau magnétique M1
- pourtour 10
- matériau M2
- périphérie latérale 22
- support amagnétique 12
- surface intérieure 14
- surface extérieure 16 (surface de travail)
- aimant 6
- surface intérieure 18
- périphérie latérale 20

## Revendications

1. Dispositif de centrage magnétique (2) et de réalisation d'un palier axial pour des organes magnétiques mobiles ou non pour des applications micromécaniques selon un axe (A), le dispositif comprenant un aimant (6) et un dispositif de conduction de flux magnétique (4) disposé sur l'aimant, le dispositif de conduction de flux magnétique comprenant une pastille centrale de conduction de flux magnétique (8) en un matériau magnétique (M1) ayant une haute perméabilité magnétique maximale, égale ou supérieure à 100, la pastille centrale (8) étant disposée sur une face de l'aimant sensiblement au centre du dispositif de manière que le flux magnétique soit centré par ladite pastille selon ledit axe (A), et un pourtour (10) disposé autour de la pastille centrale et séparé de la pastille centrale par une distance (R10) non-nulle, ledit dispositif de centrage étant **caractérisé en ce qu'**il comprend un support amagnétique (12) en un matériau ayant une faible perméabilité magnétique, le dispositif de conduction de flux magnétique étant disposé entre l'aimant et le support amagnétique, le support amagnétique présentant une surface de travail (16) contre laquelle un organe mobile peut prendre appui et ledit pourtour agissant comme entretoise entre l'aimant et le support amagnétique.

2. Dispositif selon la revendication 1, **caractérisé en ce que** le pourtour n'est pas en contact avec la pastille centrale.

3. Dispositif selon la revendication 1, **caractérisé en ce que** le pourtour et la pastille centrale sont connectés par une ou plusieurs barrettes ou par un plateau de liaison d'épaisseur égale ou inférieure à un dixième de l'épaisseur de la pastille centrale.

4. Dispositif selon l'une des revendications précédentes, **caractérisé en ce que** le pourtour est en un matériau (M2) magnétique ayant une haute perméabilité magnétique maximale, égale ou supérieure à 100.

5. Dispositif selon la revendication précédente **caractérisé en ce que** le pourtour est en un matériau identique au matériau de la pastille centrale.

6. Dispositif selon l'une des revendications précédentes, **caractérisé en ce que** le matériau de l'aimant est SmCo ou NdFeB.

7. Dispositif selon l'une des revendications précédentes, **caractérisé en ce que** le pourtour a une forme circulaire et **en ce que** la distance (R10) séparant la pastille centrale du pourtour est dans une gamme se trouvant entre 0,45 et 0,2 fois la largeur moyenne (X6) de l'aimant ou le diamètre extérieure du pourtour.

8. Dispositif selon l'une des revendications précédentes, **caractérisé en ce que** le pourtour forme un circuit fermé autour de la pastille centrale.

9. Dispositif selon l'une des revendications précédentes, **caractérisé en ce que** la pastille centrale a une forme cylindrique.

10. Dispositif selon l'une des revendications précédentes, **caractérisé en ce que** la pastille centrale a une forme de cône tronqué.

11. Dispositif selon l'une des revendications précédentes, **caractérisé en ce que** la distance minimale entre la pastille centrale et le pourtour est égale ou supérieure à 0.2 mm.

12. Dispositif selon l'une des revendications précédentes, **caractérisé en ce que** la pastille centrale est inscrite dans un cylindre de diamètre entre 5 et 30 microns et une épaisseur entre 5 et 50 microns, et le pourtour est inscrit dans une couronne cylindrique de diamètre intérieur entre 0,5 et 2 mm, et une épaisseur entre 5 et 30 microns.

13. Dispositif selon l'une des revendications précédentes, **caractérisé en ce que** la pastille centrale est inscrite dans un cône tronqué ayant une première surface de diamètre égal ou inférieur à 10 microns et une deuxième surface de diamètre égal ou inférieur à 50 microns et par une hauteur égale ou inférieure à 50 microns, la deuxième surface étant disposée plus proche de l'aimant que la première surface.

14. Dispositif selon l'une des revendications précédentes, **caractérisé en ce que** l'aimant a un diamètre entre 0,5 et 3 mm et une épaisseur entre 0.2 et 1 mm.

15. Dispositif selon l'une des revendications précédentes, **caractérisé en ce que** le dispositif de conduction de flux magnétique est formé par une technique de déposition, soit sur la surface (18) de l'aimant, soit sur la surface intérieure (14) du support amagnétique.

16. Dispositif selon l'une des revendications précédentes, **caractérisé en ce que** le matériau (M1) de la pastille centrale, le cas échéant du pourtour lorsqu'il s'agit du même matériau, est réalisé en nickel ou en cobalt ou un alliage de nickel ou un alliage de cobalt.

17. Dispositif selon l'une des revendications précédentes, **caractérisé en ce que** le dispositif de conduction de flux magnétique est obtenu par lithographie à partir d'une couche essentiellement uniforme de matière.

18. Dispositif selon l'une des revendications précédentes, **caractérisé en ce que** la surface de travail est en un matériau sélectionné d'un groupe de matériaux comprenant des saphirs, pierre de rubis, et diamant.

19. Dispositif selon l'une des trois revendications précédentes, **caractérisé en ce que** la surface du support amagnétique est creusée par usinage laser, le matériau formant la pastille centrale est ensuite déposé en couche par dépôt galvanique sur la surface creusée et le dispositif de conduction de flux magnétique est finalement formé à l'intérieur du creux par attaque mécanique ou chimique du matériau déposé.

20. Dispositif selon l'une des quatre revendications précédentes, **caractérisé en ce que** l'épaisseur du support amagnétique est entre 0.03 et 0.6 mm.

21. Dispositif selon l'une des revendications précédentes, **caractérisé en ce que** le dispositif est configuré en tant que palier magnétique pour un organe mobile pivotant ou rotatif d'un mécanisme horloger.

22. Mouvement de montre comprenant un dispositif selon l'une des revendications précédentes.

23. Montre comprenant un dispositif selon l'une des revendications précédentes.

## Patentansprüche

1. Vorrichtung zur magnetischen Zentrierung (2) und zur Herstellung eines Axiallagers für bewegliche oder unbewegliche magnetische Organe für mikromechanische Anwendungen entlang einer Achse (A), wobei die Vorrichtung einen Magneten (6) und eine auf dem Magneten angeordnete Magnetfluss-Leitungsvorrichtung (4) umfasst, wobei die Magnetfluss-Leitungsvorrichtung einen zentralen Magnetfluss-Leitungschip (8) aus einem magnetischen Material (M1) mit einer hohen maximalen magnetischen Permeabilität von gleich oder größer als 100, wobei der zentrale Chip (8) auf einer Seite des Magneten im Wesentlichen im Zentrum der Vorrichtung angeordnet ist, sodass der Magnetfluss von dem Chip entlang der Achse (A) zentriert wird, und einen Umfang (10) umfasst, der um den zentralen Chip herum angeordnet und um einen Abstand (R10) von ungleich null von dem zentralen Chip getrennt ist, wobei die Zentriervorrichtung **dadurch gekennzeichnet ist, dass** sie eine unmagnetische Stütze (12) aus einem Material mit einer geringen magnetischen Permeabilität umfasst, wobei die Magnetfluss-Leitungsvorrichtung zwischen dem Magneten und der unmagnetischen Stütze angeordnet ist, wobei die unmagnetische Stütze eine Arbeitsfläche (16) aufweist, an der ein bewegliches Organ aufliegen kann, und der Umfang als Abstandshalter zwischen dem Magneten und der unmagnetischen Stütze wirkt.

2. Vorrichtung nach Anspruch 1, **dadurch gekennzeichnet, dass** der Umfang nicht mit dem zentralen Chip in Kontakt steht.

3. Vorrichtung nach Anspruch 1, **dadurch gekennzeichnet, dass** der Umfang und der zentrale Chip durch einen oder mehrere Stege oder durch eine Verbindungsschale mit einer Dicke von gleich oder kleiner als einem Zehntel der Dicke des zentralen Chips verbunden sind.

4. Vorrichtung nach einem der vorstehenden Ansprüche, **dadurch gekennzeichnet, dass** der Umfang aus einem magnetischen Material (M2) mit einer hohen maximalen magnetischen Permeabilität von gleich oder größer als 100 besteht.

5. Vorrichtung nach dem vorstehenden Anspruch, **dadurch gekennzeichnet, dass** der Umfang aus einem Material besteht, das mit dem Material des zentralen Chips identisch ist.

6. Vorrichtung nach einem der vorstehenden Ansprüche, **dadurch gekennzeichnet, dass** es sich bei dem Material des Magneten um SmCo oder NdFeB handelt.

7. Vorrichtung nach einem der vorstehenden Ansprüche, **dadurch gekennzeichnet, dass** der Umfang eine kreisrunde Form aufweist, und dadurch, dass der Abstand (R10), der den zentralen Chip vom Umfang trennt, in einem Bereich liegt, der zwischen dem 0,45- und 0,2-fachen der durchschnittlichen Breite (X6) des Magneten oder des Außendurchmessers des Umfangs beträgt.

8. Vorrichtung nach einem der vorstehenden Ansprüche, **dadurch gekennzeichnet, dass** der Umfang einen geschlossenen Kreis um den zentralen Chip herum bildet.

9. Vorrichtung nach einem der vorstehenden Ansprüche, **dadurch gekennzeichnet, dass** der zentrale Chip eine zylindrische Form aufweist.

10. Vorrichtung nach einem der vorstehenden Ansprüche, **dadurch gekennzeichnet, dass** der zentrale Chip eine Kegelstumpfform aufweist.

11. Vorrichtung nach einem der vorstehenden Ansprüche, **dadurch gekennzeichnet, dass** der minimale Abstand zwischen dem zentralen Chip und dem Umfang gleich oder größer als 0,2 mm ist.

12. Vorrichtung nach einem der vorstehenden Ansprüche, **dadurch gekennzeichnet, dass** der zentrale Chip in einem Zylinder mit einem Durchmesser von zwischen 5 und 30 Mikrometer und einer Dicke von zwischen 5 und 50 Mikrometer umschrieben ist, und der Umfang in einer zylindrischen Krone mit einem Innendurchmesser von zwischen 0,5 und 2 mm, und einer Dicke von zwischen 5 und 30 Mikrometer umschrieben ist.

13. Vorrichtung nach einem der vorstehenden Ansprüche, **dadurch gekennzeichnet, dass** der zentrale Chip in einem Kegelstumpf mit einer ersten Fläche mit einem Durchmesser von gleich oder kleiner als 10 Mikrometer und einer zweiten Fläche mit einem Durchmesser von gleich oder kleiner als 50 Mikrometer, und durch eine Höhe von gleich oder kleiner als 50 Mikrometer umschrieben ist, wobei die zweite Fläche näher am Magneten angeordnet ist als die erste Fläche.

14. Vorrichtung nach einem der vorstehenden Ansprüche, **dadurch gekennzeichnet, dass** der Magnet einen Durchmesser von zwischen 0,5 und 3 mm und eine Dicke von zwischen 0,2 und 1 mm aufweist.

15. Vorrichtung nach einem der vorstehenden Ansprüche, **dadurch gekennzeichnet, dass** die Magnetfluss-Leitungsvorrichtung durch eine Abscheidetechnik entweder auf der Fläche (18) des Magneten, oder auf der Innenfläche (14) der unmagnetischen Stütze gebildet ist.

16. Vorrichtung nach einem der vorstehenden Ansprüche, **dadurch gekennzeichnet, dass** das Material (M1) des zentralen Chips, gegebenenfalls des Umfangs, wenn es sich um das gleiche Material handelt, aus Nickel oder aus Kobalt oder einer Nickellegierung oder einer Kobaltlegierung hergestellt ist.

17. Vorrichtung nach einem der vorstehenden Ansprüche, **dadurch gekennzeichnet, dass** die Magnetfluss-Leitungsvorrichtung durch Lithographie auf Grundlage einer im Wesentlichen einheitlichen Materialschicht erhalten wird.

18. Vorrichtung nach einem der vorstehenden Ansprüche, **dadurch gekennzeichnet, dass** die Arbeitsfläche aus einem Material besteht, ausgewählt aus einer Gruppe von Materialien, die Saphire, Rubinstein, und Diamant umfasst.

19. Vorrichtung nach einem der drei vorstehenden Ansprüche, **dadurch gekennzeichnet, dass** die Fläche der unmagnetischen Stütze durch Laserbearbeitung ausgehöhlt wird, das Material, das den zentralen Chip bildet, anschließend durch galvanische Abscheidung als Schicht auf der ausgehöhlten Fläche abgeschieden wird, und die Magnetfluss-Leitungsvorrichtung zu guter Letzt im Inneren der Aushöhlung durch mechanische oder chemische Beize des abgeschiedenen Materials gebildet wird.

20. Vorrichtung nach einem der vier vorstehenden Ansprüche, **dadurch gekennzeichnet, dass** die Dicke der unmagnetischen Stütze zwischen 0,03 und 0,6 mm beträgt.

21. Vorrichtung nach einem der vorstehenden Ansprüche, **dadurch gekennzeichnet, dass** die Vorrichtung als magnetisches Lager für ein schwenk- oder drehbewegliches Organ eines Uhrenmechanismus ausgelegt ist.

22. Uhrwerk, das eine Vorrichtung nach einem der vorstehenden Ansprüche umfasst.

23. Uhr, die eine Vorrichtung nach einem der vorstehenden Ansprüche umfasst.

## Claims

1. Device for magnetic centring (2) and for producing an axial bearing for magnetic members that may or may not be mobile for micromechanical applications according to an axis (A), the device including a magnet (6) and a magnetic flux conduction device (4) arranged on the magnet, the magnetic flux conduction device including a central magnetic flux conduction disc (8) made of a magnetic material (M1) having a maximum high magnetic permeability equal to or greater than 100, the central disc (8) being disposed on a face of the magnet which is substantially at the centre of the device so that the magnetic flux is centred by said disc according to said axis (A), and a peripheral area (10) arranged around the central disc and separated from the central disc by a non-zero distance (R10), said centring device being **characterised in that** it includes a non-magnetic support (12) made of a material having low magnetic permeability, the magnetic flux conduction device being disposed between the magnet and the non-magnetic support, the non-magnetic support having a work surface (16) against which a mobile member can bear and said peripheral area acting as a spacer between the magnet and the non-magnetic support.

2. Device according to claim 1, **characterised in that** the peripheral area is not in contact with the central disc.

3. Device according to claim 1, **characterised in that** the peripheral area and the central disc are connected by one or more bars or by a connecting plate whose thickness is equal to or less than one tenth of the thickness of the central disc.

4. Device according to any of the preceding claims, **characterised in that** the peripheral area is made of a magnetic material (M2) having a high maximum magnetic permeability, equal to or greater than 100.

5. Device according to the preceding claim, **characterised in that** the peripheral area is made of an identical material to the material of the central disc.

6. Device according to any of the preceding claims, **characterised in that** the material of the magnet is SmCo or NdFeB.

7. Device according to any of the preceding claims, **characterised in that** the peripheral area has a circular shape and **in that** the distance (R10) separating the central disc from the peripheral area is in a range of between 0.45 and 0.2 times the mean width (X6) of the magnet or the outer diameter of the peripheral area.

8. Device according to any of the preceding claims, **characterised in that** the peripheral area forms a closed circuit around the central disc.

9. Device according to any of the preceding claims, **characterised in that** the central disc has a cylindrical shape.

10. Device according to any of the preceding claims, **characterised in that** the central disc has a truncated cone shape.

11. Device according to any of the preceding claims, **characterised in that** the minimum distance between the central disc and the peripheral area is equal to or greater than 0.2 mm.

12. Device according to any of the preceding claims, **characterised in that** the central disc is inscribed in a cylinder having a diameter of between 5 and 30 microns and a thickness of between 5 and 50 microns, and the peripheral area is inscribed in a cylindrical crown having an inner diameter of between 0.5 and 2 mm, and a thickness of between 5 and 30 microns.

13. Device according to any of the preceding claims, **characterised in that** the central disc is inscribed in a truncated cone having a first surface whose diameter is equal to or less than 10 microns and a second surface whose diameter is equal to or less than 50 microns and a height equal to or less than 50 microns, the second surface being disposed closer to the magnet than the first surface.

14. Device according to any of the preceding claims, **characterised in that** the magnet has a diameter of between 0.5 and 3 mm and a thickness of between 0.2 and 1 mm.

15. Device according to any of the preceding claims, **characterised in that** the magnetic flux conduction device is formed by a deposition technique, either on the surface (18) of the magnet, or on the inner surface (14) of the non-magnetic support.

16. Device according to any of the preceding claims, **characterised in that** the material (M1) of the central disc, and possibly of the peripheral area when the material is the same, is made of nickel or of cobalt or a nickel alloy or a cobalt alloy.

17. Device according to any of the preceding claims, **characterised in that** the magnetic flux conduction device is obtained by lithography from an essentially uniform layer of material.

18. Device according to any of the preceding claims, **characterised in that** the work surface is made of a material selected from a group of materials including sapphires, ruby stones, and diamond.

19. Device according to any of the preceding three claims, **characterised in that** the surface of the non-magnetic support is hollowed by laser machining, the material forming the central disc is then deposited in a layer by galvanic deposition on the hollowed surface and the magnetic flux conduction device is finally formed inside the hollow by mechanical or chemical etching of the deposited material.

20. Device according to any of the preceding four claims, **characterised in that** the thickness of the non-magnetic support is between 0.03 and 0.6 mm.

21. Device according to any of the preceding claims, **characterised in that** the device is configured as a magnetic bearing for a pivoting or rotating mobile member of a timepiece mechanism.

22. Watch movement including a device according to any of the preceding claims.

23. Watch including a device according to any of the preceding claims.
